Europäisches Patentamt

European Patent Office

Office européen des brevets

(19)

(11) EP 0 663 666 B1

(12) EUROPÄISCHE PATENTSCHRIFT

(45) Veröffentlichungstag und Bekanntmachung des Hinweises auf die Patenterteilung:
03.03.1999  Patentblatt 1999/09

(51) Int Cl.⁶: **G11C 11/409**

(21) Anmeldenummer: 94119877.2

(22) Anmeldetag: 15.12.1994

(54) **Integrierte Halbleiterspeicherschaltung und Verfahren zu ihrem Betrieb**

Integrated semiconductor memory circuit and operation thereof

Circuit intégré de mémoire à semi-conducteurs et méthode d'opération

(84) Benannte Vertragsstaaten:
**AT DE FR GB IE IT NL**

(30) Priorität: **12.01.1994  DE 4400698**

(43) Veröffentlichungstag der Anmeldung:
**19.07.1995  Patentblatt 1995/29**

(73) Patentinhaber: **SIEMENS AKTIENGESELLSCHAFT**
**80333 München (DE)**

(72) Erfinder: **von der Ropp, Thomas, Dr., Dipl.-Phys.**
**D-82110 Germering (DE)**

(56) Entgegenhaltungen:
**EP-A- 0 398 244        US-A- 4 027 294**

• **IBM TECHNICAL DISCLOSURE BULLETIN, Bd.31, Nr.3, August 1988, NEW YORK US Seiten 289 - 290 'Complementary Referencing for Dynamic Array Sensing'**

**Beschreibung**

Die Erfindung betrifft eine integrierte Halbleiterspeicherschaltung mit den Merkmalen des Oberbegriffes nach Patentanspruch 1 sowie ein Verfahren zum Betreiben derselben. Eine solche Halbleiterspeicherschaltung ist beispielsweise aus EP-A-0 398 244 bekannt.

Bei integrierten Halbleiterspeicherschaltungen ist es allgemein üblich, vor einem Auslesen von Daten aus den Speicherzellen MC die Bitleitungen BL auf ein Bitleitungspotential VBL vorzuladen (allgemein als Precharge-Vorgang bzw. mit Precharge-Potential bezeichnet). Dies dient dazu, den Leseverstärkern SA (die ja im allgemeinen Flip-Flop-Schaltungen sind, die differenziell arbeiten) nach dem Auslesen zur Bewertung und Verstärkung der Lesesignale effektiv nur diese zuzuführen, weil das Bitleitungspotential VBL an beiden Eingängen der Leseverstärker SA mit dem selben Wert anliegt und somit von den differenziell arbeitenden Leseverstärkern SA nicht berücksichtigt wird. Während in der Vergangenheit als Bitleitungspotential VBL meist entweder das Versorgungsspannungspotential VDD oder das Bezugspotential VSS angelegt wurde, legt man heutzutage meist einen Wert an, der der halben Differenz aus Versorgungsspannungspotential VDD und Bezugspotential VSS entspricht bzw. bei solchen Halbleiterspeicherschaltungen, die schaltungsintern mit einem gegenüber dem am fertigen Baustein anliegenden Versorgungspotential VDD erniedrigten sogenannten internen Versorgungsspannungspotential VDDint arbeiten, legt man die entsprechende halbe Differenz zwischen diesem internen Versorgungsspannungspotential VDDint und dem Bezugspotential VSS an.

Soweit die herkömmliche Halbleiterspeicherschaltung auch sogenannte Dummy-Zellen aufweist, werden herkömmlicherweise auch diese auf das Bitleitungspotential VBL aufgeladen.

Bekanntlich sind integrierte Halbleiterspeicherschaltungen, insbesondere vom lTransistor-Speicherzellentyp (sogenannte 1T-DRAM's bzw. embedded 1T-DRAM's), empfindlich gegenüber sogenannten Soft-Errors, d.h. gegenüber Alphastrahlen, die meist vom verwendeten Bausteingehäuse herrühren. Versuche haben gezeigt, daß die herkömmlichen Halbleiterspeicherschaltungen unterschiedlich stark auf diese Alphastrahlen reagieren, je nachdem, ob ein Datum als physikalische 0 oder als physikalische 1 zu speichern war (eine physikalische 0 kann einem Datum log. 0 entsprechen; sie kann aber auch einem Datum log. 1 entsprechen; die Zuordnung ist abhängig von der jeweils gewählten Schaltungstechnik). Es hat sich gezeigt, daß dies Folge einer sogenannten Bewertungsunsymmetrie der Leseverstärker SA ist, so daß z.B. ein gespeichertes Datum phys. 0 nicht mit derselben Sicherheit und denselben Sicherheitsmargins auslesbar ist wie ein gespeichertes Datum phys. 1 und umgekehrt. Damit jedoch nimmt die Gefahr des Auftretens von Soft-Errors bezüglich der einen Datumsart zu, während sie gegenüber der anderen Datumsart abnimmt. Dies ist insoweit unerwünscht, weil man gern für beide Datumsarten eine gleich gute Sicherheit gegenüber Soft-Errors haben will.

Als Ausweg böte sich an, die Speicherzellenkapazitäten zu vergrößern, wodurch das Lesesignal größer würde und die Halbleiterspeicherschaltung somit insgesamt sicherer gegenüber Soft-Errors. Allerdings ist dieser Weg in der Praxis nicht gangbar, weil dies eine laterale und/oder räumliche Vergrößerung der Speicherzellen zur Folge hätte, was bei den heute bestehenden Anforderungen an Miniaturisierung von Halbleiterspeicherschaltungen nicht gewünscht ist (die Folge wären größere Speicherchips und ggf. dazu notwendige größere Gehäuse, die dann unter Umständen nicht mehr den geltenden Normen entsprechen).

Aufgabe der vorliegenden Erfindung ist es, gattungsgemäße integrierte Halbleiterspeicherschaltungen so zu optimieren, daß ihre Leseverstärker die Daten phys. 0 und phys. 1 mit annähernd gleicher Sicherheit erkennen können (sog. Symmetrierung der Leseverstärker bezüglich phys. 0 und phys. 1), ohne dazu die Speicherzellen vergrößern zu müssen und ohne dabei eine Einbuße an Sicherheit gegenüber Soft-Errors in Kauf nehmen zu müssen. Aufgabe ist es auch, ein entsprechendes Betriebsverfahren für eine solche Halbleiterspeicherschaltung anzugeben.

Diese Aufgabe wird gelöst durch die kennzeichnenden Merkmale der Patentansprüche 1 und 3. Vorteilhafte Weiterbildungen sind in Unteransprüchen gekennzeichnet.

Die vorliegende Erfindung ermöglicht es, die Soft-Error-Rate um zwei Größenordnungen zu senken im Vergleich zu den bekannten, gattungsgemäßen Halbleiterspeicherschaltungen.

Nachstehend wird die Erfindung anhand einer Figur erläutert, welche auch vorteilhafte Weiterbildungen enthält.

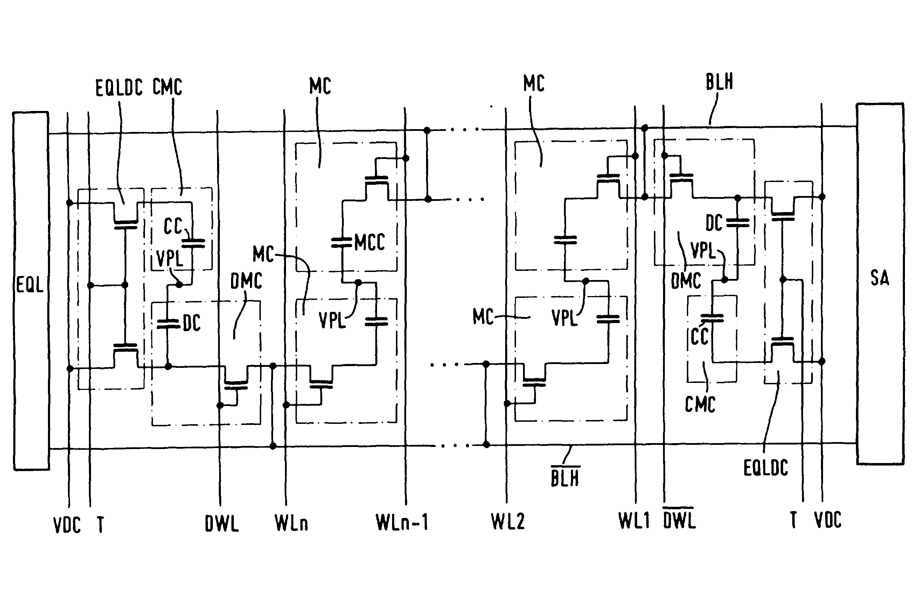

Die Figur zeigt einen Ausschnitt aus einer erfindungsgemäßen Halbleiterspeicherschaltung, bei der aus Gründen der Übersichtlichkeit nur für die Erfindung wesentliches dargestellt wurde. Gezeigt ist eine Bitleitung BL mit ihren beiden Bitleitungshälften BLH, $\overline{BLH}$, an die auf der einen Seite ein Leseverstärker SA angeschlossen ist und auf der anderen Seite eine Vorladeeinrichtung EQL zum Vorladen und (bezüglich ihres elektrischen Potentials) Gleichsetzen der Bitleitungshälften BLH, $\overline{BLH}$ auf ein Bitleitungspotential VBL vor einem Auslesen von Daten aus Speicherzellen MC. Der Wert des Bitleitungspotentials kann, wie bereits angegeben, den Wert des Versorgungsspannungspotentials VDD (oder den des internen Versorgungsspannungspotentials VDDint) oder den des Bezugspotentials VSS aufweisen. Er kann aber auch, was heutzutage üblich ist, den halben Wert der Differenz aus dem Versorgungsspannungspotential VDD (bzw. dem internen Versorgungsspannungspotential VDDint) und dem Bezugspotential VSS aufweisen. Weiterhin sind Speicherzellen MC vom 1Transistor-Typ gezeigt (mit Auswahltransistoren MCT und Speicherkondensatoren MCC), die einerseits mit der jeweiligen Bitleitungshälfte BLH, $\overline{\text{BLH}}$ verbunden sind und andererseits (an den ersten Elektroden ihrer Speicherkondensatoren MCC) alle gemeinsam mit einem sogenannten Plattenpotential VPL. Dieses weist im wesentlichen den halben Wert der Differenz aus Versorgungsspannungspotential VDD (bzw. internem Versorgungspotential VDDint) und Masse VSS auf. Es kann somit im wesentlichen gleich dem Bitleitungspotential VBL sein, welches über die Vorladeeinrichtung EQL an die Bitleitungen BL anlegbar ist. Das Plattenpotential VPL könnte auch, wie in der Vergangenheit üblich, im wesentlichen den Wert des Versorgungsspannungspotentials VDD (bzw. den des internen Versorgungsspannungspotentials VDDint) oder Masse VSS aufweisen.

Weiterhin zeigt die Figur Wortleitungen WL (durchnummeriert von WL1 bis WLn) zur Ansteuerung der Auswahltransistoren MCT der Speicherzellen MC. Die Speicherzellen MC sind also, wie allgemein üblich, an Kreuzungspunkten zwischen Wort leitungen WL und Bitleitungen BL angeordnet und über ihre Auswahltransistoren MCT zum Lesen und Speichern von Informationen mit den jeweiligen Bitleitungen BL bzw. Bitleitungshälften BLH; $\overline{\text{BLH}}$ verbindbar.

Jede Bitleitungshälfte BLH, $\overline{\text{BLH}}$ weist (beispielsweise, wie dargestellt, an ihren Enden angeordnet) eine sogenannte Dummyzelle DMC auf, die ebenfalls vom lTransistor-Zelltyp ist. Dies dient, wie allgemein bekannt, einer gleichmäßigen und symmetrischen Belastung der differenziell arbeitenden Leseverstärker SA im Betrieb. Auch die Speicherkondensatoren DC der Dummy-Zellen DMC sind an ihren ersten Elektroden mit dem Plattenpotential VPL verbunden.

Zwar zeigt die Figur noch Randzellen CMC, die allgemein als "friendly cells" bezeichnet werden, doch werden diese erst später beschrieben, da sie für die vorliegende Erfindung nicht unbedingt notwendig sind.

Die bislang geschilderte Halbleiterspeicherschaltung entspricht voll dem Stand der Technik. Erfindungsgemäß weist diese Halbleiterspeicherschaltung jedoch noch zusätzlich Vorrichtungen EQLDC auf, mittels deren die jeweils zweiten Elektroden der Speicherkondensatoren DC der Dummyspeicherzellen DMC im Betrieb mit einem Vorladepotential VDC beaufschlagbar sind. Das Beaufschlagen erfolgt erfindungsgemäß während des (üblichen) Vorladens der Bitleitungen BL auf das Bitleitungspotential VBL. Der Wert des Vorladepotentials VDC ist erfindungsgemäß 5 bis 35% größer als der Wert des Bitleitungspotentials VBL.

Die Vorrichtungen EQLDC können beispielsweise, wie dargestellt, Transistoren enthalten, die einerseits mit dem Vorladepotential VDC verbunden sind und andererseits mit den zweiten Elektroden der Speicherkondensatoren DC der Dummy-Zellen DMC. Die Transistoren sind gatemäßig von einem Vorladetaktsignal T angesteuert, welche im Zeitpunkt des Vorladens die Transistoren leitend schalten. Das Vorladetaktsignal T kann denselben zeitlichen Verlauf aufweisen wie ein entsprechendes (nicht dargestelltes) Taktsignal, welches vor einem Auslesen von Daten aus den Speicherzellen MC das Vorladen der Bitleitungen BL auf ihr Bitleitungspotential VBL steuert.

Die Figur zeigt auch, wie bereits erwähnt, daß Vorhandensein von Randzellen CMC, welche im allgemeinen als "friendly cells" bezeichnet werden. Ihre Funktion ist dem Fachmann bekannt. Sie können entweder lediglich aus Randzellenkondensatoren CC bestehen, wie hier dargestellt. Sie können aber auch darüber hinaus noch Transistoren enthalten, ähnlich den Auswahltransistoren MCT von Speicherzellen MC oder denen von Dummy-Zellen DMC. In vorteilhafter Weise sind bei der vorliegenden Erfindung die ersten Elektroden der Randzellenkondensatoren CC mit dem Plattenpotential VPL verbunden und die zweiten Elektroden dieser Randzellenkondensatoren CC sind mittels der Ausgleichsvorrichtungen EQLDC für die Dummy-Zellen DMC ebenfalls mit dem Vorladepotential VDC der Dummy-Zellen DMC beaufschlagbar. Dies ergibt dann eine noch bessere Symmetriesierung der Arbeits- und Belastungsverhältnisse der Leseverstärker SA beim Auslesen sowie Bewerten und Verstärken der ausgelesenen Daten.

## Patentansprüche

1. Integrierte Halbleiterspeicherschaltung

   - mit Speicherzellen (MC) vom lTransistor-Typ, die jeweils einen Auswahltransistor und wenigstens einen Speicherkondensator (MCC) enthalten und die matrixförmig an Kreuzpunkten von Wortleitungen (WL; WL1...WLn) mit Bitleitungen (BL) angeordnet sind,

   - wobei jede Bitleitung (BL) aus zwei Bitleitungshälften (BLH, $\overline{\text{BLH}}$) gebildet ist und

   - wobei jede Speicherzelle (MC) einerseits über ihren Auswahltransistor mit einer jeweiligen Bitleitungshälfte (BLH; $\overline{\text{BLH}}$) verbunden ist und wobei andererseits eine erste Elektrode des wenigstens einen Speicherkondensators (MCC) im Betrieb mit einem Plattenpotential (VPL) eines vorgegebenen Wertes verbunden ist,

   - mit mindestens einer, ebenfalls wenigstens einen Speicherkondensator (DC) enthaltenden Dummyspeicherzelle (DMC) je Bitleitungshälfte (BLH; $\overline{\text{BLH}}$), wobei ebenfalls eine erste Elektrode des wenigstens einen Speicherkondensators (DC) im Betrieb mit dem Plattenpotential (VPL) verbunden ist, sowie

   - mit einer Einrichtung (EQL) zum Vorladen der Bitleitungen (BL) auf ein Bitleitungspotential (VBL),

mit Vorrichtungen (EQLDC), mittels derer jeweils zweite Elektroden der Speicherkondensatoren (DC) der Dummyspeicherzellen (DMC) im Betrieb mit einem Vorladepotential (VDC) beaufschlagbar sind,

**gekennzeichnet dadurch**, daß das Vorladepotential einen Wert aufweist, der um 5 bis 35% größer ist als der Wert des Bitleitungspotentials (VBL).

2. Integrierte Halbleiterspeicherschaltung nach Anspruch 1, mit wenigstens einer Randzelle (CMC) je Bitleitungshälfte (BLH; $\overline{BLH}$), die wenigstens einen Randzellenkondensator (CC) enthält, dessen erste Elektrode mit dem Plattenpotential (VPL) verbunden ist,

**dadurch gekennzeichnet,**

daß die zweite Elektrode des Randzellenkondensators (CC) mit dem Vorladepotential (VDC) beaufschlagbar ist.

3. Verfahren zum Betreiben einer integrierten Halbleiterspeicherschaltung mit den Merkmalen der Ansprüche 1 oder 2, bei dem vor einem Auslesen von in Speicherzellen (MC) gespeicherten Daten die Bitleitungen (BL) auf das Bitleitungspotential (VBL) vorgeladen werden,

wobei beim Vorladen der Bitleitungen (BL) das Vorladepotential (VDC) an die zweiten Elektroden der Speicherkondensatoren (DC) der Dummyspeicherzellen (DMC) angelegt wird.

4. Verfahren nach Anspruch 3,

wobei beim Vorladen der Bitleitungen (BL) das Vorladepotential (VDC) auch an die zweiten Elektroden der Randzellenkondensatoren (CC) angelegt wird.

**Claims**

1. Integrated semiconductor memory circuit

- having memory cells (MC) of the 1-transistor type which each contain a selection transistor and at least one storage capacitor (MCC) and are arranged in matrix form at points where word lines (WL; WL1...WLn) cross bit lines (BL),
- each bit line (BL) being formed from two bit line halves (BLH; $\overline{BLH}$) and
- each memory cell (MC), on the one hand, being connected via its selection transistor to a respective bit line half (BLH; $\overline{BLH}$), and, on the other hand, a first electrode of the at least one storage capacitor (MCC) being connected, during operation, to a plate potential (VPL) of a predetermined value,

- having at least one dummy memory cell (DMC), likewise containing at least one storage capacitor (DC), per bit line half (BLH; $\overline{BLH}$), a first electrode of the at least one storage capacitor (DC) likewise being connected to the plate potential (VPL) during operation, and
- having a device (EQL) for precharging the bit lines (BL) to a bit line potential (VBL),

having apparatuses (EQLDC) by means of which a precharge potential (VDC) can be applied in each case to second electrodes of the storage capacitors (DC) of the dummy memory cells (DMC) during operation,

characterized in that the precharge potential has a value which is 5 to 35% greater than the value of the bit line potential (VBL).

2. Integrated semiconductor memory circuit according to Claim 1, having at least one edge cell (CMC) per bit line half (BLH; $\overline{BLH}$), which contains at least one edge cell capacitor (CC) whose first electrode is connected to the plate potential (VPL),

characterized

in that

the precharge potential (VDC) can be applied to the second electrode of the edge cell capacitor (CC).

3. Method for operating an integrated semiconductor memory circuit having the features of Claims 1 or 2, in which prior to a read-out of data stored in memory cells (MC), the bit lines (BL) are precharged to a bit line potential (VBL),

the precharge potential (VDC) being applied to the second electrodes of the storage capacitors (DC) of the dummy memory cells (DMC) during the precharging of the bit lines (BL).

4. Method according to Claim 3,

the precharge potential (VDC) also being applied to the second electrodes of the edge cell capacitors (CC) during the precharging of the bit lines (BL).

**Revendications**

1. Circuit intégré de mémoire à semi-conducteurs

- comportant des cellules (MC) de mémoire du type à un transistor qui contiennent chacune un transistor de sélection et au moins un condensateur (MCC) à accumulation et qui sont disposées de manière matricielle, aux points d'intersection de lignes (WL ; WL1 ... WLn) de transmission de mots et de lignes (BL) de transmission de bits,
- chaque ligne (BL) de transmission de bits étant formée par deux moitiés (BLH, $\overline{BLH}$) de lignes

de transmission de bits, et

- chaque cellule (MC) de mémoire étant, d'une part, reliée à une moitié (BLH, $\overline{BLH}$) de lignes de transmission de bits associées par l'intermédiaire de son transistor de sélection et une première électrode de l'au moins un condensateur (MCC) à accumulation étant, d'autre part, reliée au cours du fonctionnement à un potentiel (VPL) de plaque d'une valeur prescrite,

- comportant au moins une cellule (DMC) de mémoire Dummy, contenant également au moins un condensateur (DC) à accumulation, pour chaque moitié (BLH ; $\overline{BLH}$) de transmission de lignes, une première électrode de l'au moins un condensateur (DC) à accumulation étant également reliée pendant le fonctionnement au potentiel (VPL) de plaque, ainsi que

- comportant un dispositif (EQL) pour précharger les lignes (BL) de transmission de bits à un potentiel (VBL) de lignes transmission de bits,

- comportant des dispositifs (EQLDC) au moyen desquels chacune des deuxièmes électrodes des condensateurs (DC) à accumulation des cellules (DMC) de mémoire Dummy peut être mise pendant le fonctionnement à un potentiel (VDC) de précharge,

  caractérisé en ce que le potentiel de précharge a une valeur qui est supérieure de 5 à 35 % à la valeur du potentiel (VBL) de lignes de transmission de bits.

2. Circuit intégré de mémoire à semi-conducteurs suivant la revendication 1, comportant au moins une cellule (CMC) marginale par moitié (BLH ; $\overline{BLH}$) de lignes de transmission de bits, qui contient au moins un condensateur (CC) à cellules de bord dont la première électrode est reliée au potentiel (VPL) de plaque, caractérisé en ce que la deuxième électrode du condensateur (CC) à cellules de bord peut être mise au potentiel (VDC) de précharge.

3. Procédé pour faire fonctionner un circuit intégré de mémoire à semi-conducteurs comportant les caractéristiques des revendications 1 ou 2, dans lequel, avant une lecture de données mémorisées dans des cellules (MC) de mémoire, on précharge les lignes (BL) de transmission de bits au potentiel (VBL) de lignes de transmission de bits, le potentiel (VDC) de précharge étant, lors de la précharge des lignes (BL) de transmission de bits, appliqué aux deuxièmes électrodes des condensateurs (DC) à accumulation des cellules (DMC) de mémoire Dummy.

4. Procédé suivant la revendication 3, dans lequel lors de la précharge des lignes (BL) de transmission de bits, on applique le potentiel (VDC) de précharge aussi aux deuxièmes électrodes des condensateurs (CC) à cellules de bord.

EQLDC CMC   MC   MC   BLH

EQL

CC
VPL
DC

DMC

MCC

VPL

MC

MC

VPL

DC
VPL
DMC

CC
CMC

$\overline{BLH}$

EQLDC

SA

VDC T   DWL   WLn   WLn-1   WL2   WL1 $\overline{DWL}$   T VDC

EP 0 663 666 B1